Europäisches Patentamt

European Patent Office

Office européen des brevets

(11) Publication number: **0 177 909**
**A2**

# (12) EUROPEAN PATENT APPLICATION

(21) Application number: **85112619.3**

(22) Date of filing: **04.10.85**

(51) Int. Cl.⁴: **H 03 M 1/78**

(30) Priority: **09.10.84 JP 212384/84**

(43) Date of publication of application: **16.04.86**
**Bulletin 86/16**

(84) Designated Contracting States: **DE GB NL**

(71) Applicant: **Nippon Gakki Seizo Kabushiki Kaisha, 10-1, Nakazawa-cho, Hamamatsu-shi Shizuoka-ken (JP)**

(72) Inventor: **Kohdaka, Takayuki, c/o NIPPON GAKKI SEIZO K.K. 10-1, Nakazawa-cho, Hamamatsu-shi Shizuoka-ken (JP)**
Inventor: **Ishida, Katsuhiko, c/o NIPPON GAKKI SEIZO K.K. 10-1, Nakazawa-cho, Hamamatsu-shi Shizuoka-ken (JP)**
Inventor: **Takahashi, Toshiyuki, c/o NIPPON GAKKI SEIZO K.K. 10-1, Nakazawa-cho, Hamamatsu-shi Shizuoka-ken (JP)**
Inventor: **Ogata, Takashi, c/o NIPPON GAKKI SEIZO K.K. 10-1, Nakazawa-cho, Hamamatsu-shi Shizuoka-ken (JP)**

(74) Representative: **Kehl, Günther, Dipl.-Phys. et al, Patentanwälte GEYER, HAGEMANN & KEHL Ismaninger Strasse 108 Postfach 86 03 29, D-8000 München 86 (DE)**

(54) **Digital-to-analog converter.**

(57) A digital-to-analog converter comprises a digital-to-analog converting section for converting digital input data into an analog output signal and an error correction circuit. The error correction circuit selectively generates one of different amount of analog signals in response to a specific state of a predetermined bit of the binary input data, the amount of the generated analog signal being a $2^{-N}$ (N is an integer) magnification of that amount of the analog output signal which corresponds to the least significant bit of the binary input data. The thus generated analog signal is fed to the digital-to-analog converting section to shift the analog output signal by the amount of the generated analog signal.

## DIGITAL-TO-ANALOG CONVERTER

This invention relates to a digital-to-analog converter for converting a digital input signal into an analog form, and more particularly to such a digital-to-analog converter which is provided with an error correction circuit.

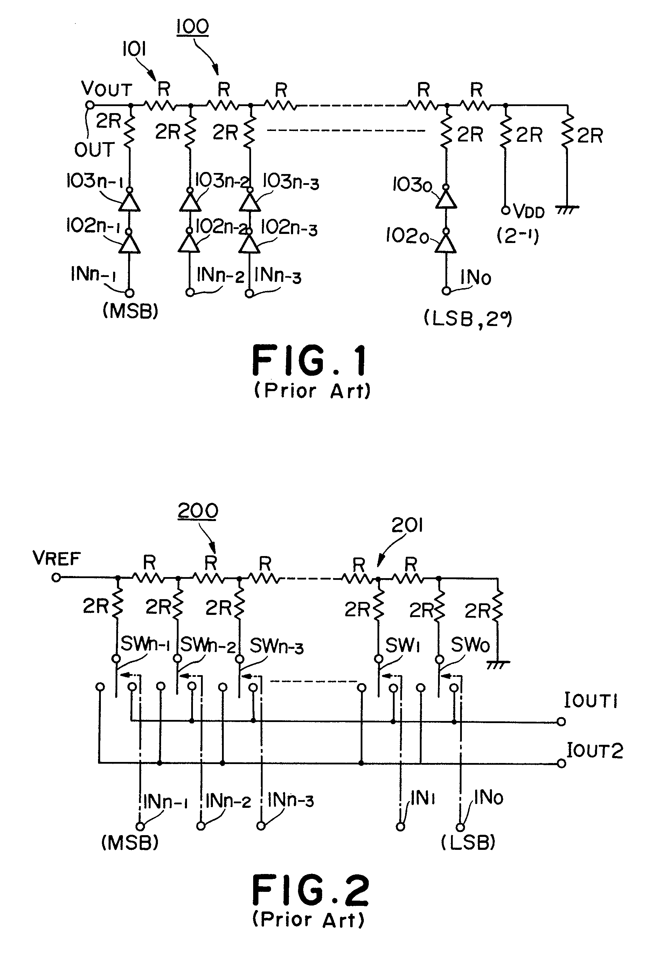

There has been proposed various kinds of digital-to-analog converters (hereinafter referred to as "D/A converters"). One of the conventional voltage-output type D/A converters is shown in Fig. 1. This n-bit D/A converter 100 comprises an R-2R ladder network 101 and n groups of serially connected inverters 102 and 103. N-bit digital input data is applied to input terminals $IN_{n-1}$ to $IN_0$, and each bit of the input data is supplied to the 2R corresponding resistor of the ladder network 101 through the corresponding inverters 102 and 103. The inverters 103 outputs a voltage equal to $V_{DD}$ as a logical "1" and outputs a ground voltage as a logical "0", and an output voltage $V_{OUT}$ of this D/A converter 100 is taken from the junction point of the 2R and R resistors of the MSB (most significant bit) stage of the ladder network 101 through an output terminal OUT. The ladder network 101 is provided with a $2^{-1}$-bit stage (the stage one bit lower than the $2^0$-bit stage or the LSB stage) whose 2R resistor is biased by a voltage $V_{DD}$. With this D/A converter, an analog voltage $V_{OUT}$ proportional to the value of the digital input data appears at the output terminal OUT.

Fig. 2 shows one example of the conventional current-output type D/A converters. This D/A converter 200 comprises an R-2R ladder network 201 and double-pole analog switches $SW_{n-1}$ to $SW_0$. Each of the analog switches $SW_{n-1}$ to $SW_0$ may be composed of a pair of field effect transistors complementarily connected to each other. The junction point of the R and 2R registers of the MSB stage of the R-2R ladder network 201 is supplied with a reference voltage of $V_{REF}$. N-bit digital input data is applied to input terminals $IN_{n-1}$ to $IN_0$, and the switches $SW_{n-1}$ to $SW_0$ are controlled by the respective bits of the digital input data. An analog output signal in the form of current is taken from a pair of output terminals $I_{OUT1}$ and $I_{OUT2}$, the output terminal $I_{OUT1}$ being connected to one of the contacts of each of the switches $SW_{n-1}$ to $SW_0$ and the output terminal $I_{OUT2}$ being connected to the other of the contacts of each of the switches $SW_{n-1}$ to $SW_0$.

It is well known that the accuracy of a D/A converter is subject to errors existing in inverters, analog switches, wiring and resistors of the associated ladder network. And to improve the accuracy of a D/A converter, one of the following methods has conventionally been taken:

(a) trimming respective resistors in the ladder network to correct the conversion error; and

(b) storing the difference between the output value and the reference value into a memory such as a RAM or a ROM, and correcting the output value by driving an associated error correction circuit in accordance with the stored difference.

However, the above method (a) is disadvantageous in that it requires an expensive trimming apparatus and the skilled operation thereof. This increases the manufacturing cost of the D/A converter. Also, the method (b) is disadvantageous in that the D/A converter must be associated with a memory circuit and a precise reference voltage source and therefore becomes expensive and large in size. In addition, in the case where a RAM is used for storing the difference, the correction operation must be carried out periodically, for example, at a time interval of about ten minutes, so that the D/A converter is not easy to use.

It is therefore an object of the present invention to provide a D/A converter having a high conversion accuracy.

It is another object of the present invention to provide such a D/A converter which can obviate the need for trimming of resistors, a memory circuit or a precise reference voltage source for error correction.

According to one aspect of the present invention, there is provided a digital-to-analog converter comprising digital-to-analog converting means for converting multi-bit digital input data into an analog output signal which is proportional in amount to said digital input data, said digital-to-analog converter characterized by the provision of error correction circuit means operatively connected to said digital-to-analog converting means for shifting said analog output signal by a predetermined amount in accordance with a preselected bit of said digital input data. In this case, it is advantageous that the error correction circuit means shifts said analog output signal selectively by one of a plurality of predetermined amounts in accordance with the preselected bit of said digital input data. Also, the preselected bit is preferably the most significant bit of said digital input data. Furthermore, the error correction circuit means may comprise enabling circuit means responsive to a specific state of said bit of said digital input data for generating an enabling signal and signal generating means responsive to said enabling signal for generating an analog signal whose amount is a $2^{-N}$ (N is an integer) magnification of that amount of said analog output signal which corresponds to the least significant bit of said digital input data, said generated analog signal being fed to said digital-to-analog converting means to cause said analog output signal to be shifted by the amount of said generated analog signal. The error correction circuit means may be modified to comprise enabling circuit means responsive to a specific state of said bit of said digital input data for generating an enabling signal; an input terminal for receiving a selection signal; and analog signal generating means responsive to said enabling and selection signals for selectively generating one of a plurality of analog signals whose amounts are $2^{-N}$ (N are integers) magnifications of that amount of said analog output signal which corresponds to the least significant bit of said digital input data, said selectively generated analog signal being fed to said digital-to-analog converting means to cause said analog output signal to be shifted by the amount of said selectively generated analog signal.

The embodiments of the present invention will now be described with reference to the accompanying drawings, in which:-

Fig. 1 is a circuit diagram of a conventional voltage-output type D/A converter;

Fig. 2 is a circuit diagram of a conventional current-output type D/A converter;

Fig. 3 is a circuit diagram of a D/A converter showing an embodiment of the present invention applied to the voltage-output type;

Fig. 4 is a circuit diagram of a modification of the D/A converter shown in Fig. 3; and

Fig. 5 is a circuit diagram of a D/A converter showing an embodiment of the present invention applied to the current-output type.

The embodiments of the present invention will now be described with reference to the accompanying drawings in which like reference characters denote corresponding parts in several views.

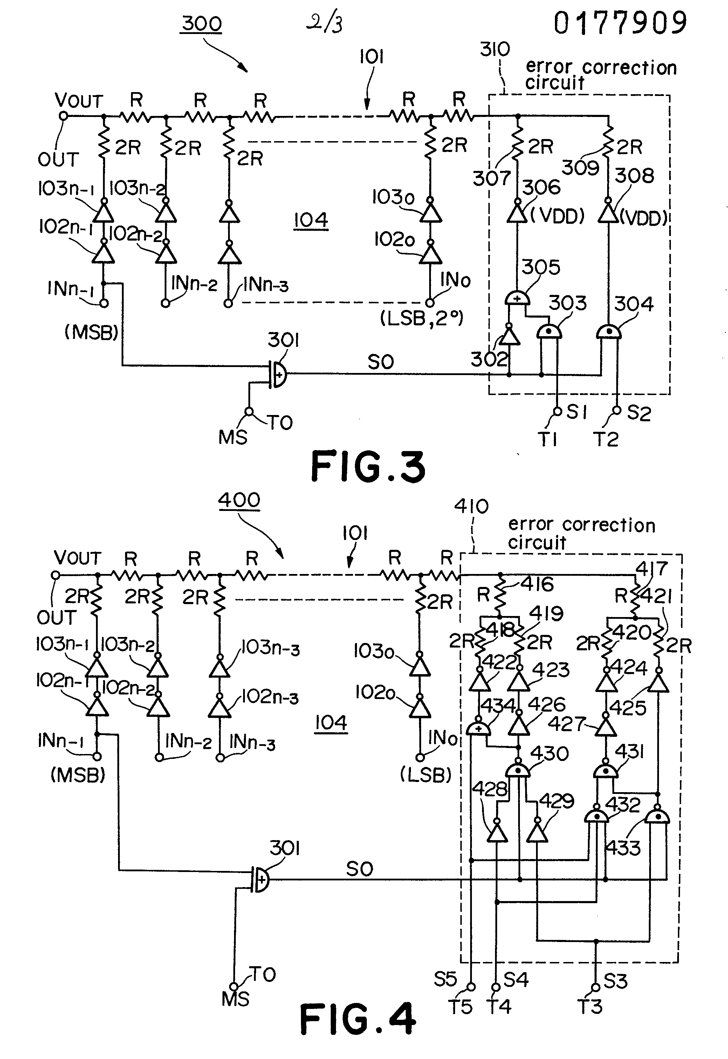

Fig. 3 shows a D/A converter 300 provided in accordance with the present invention. This D/A converter 300 comprises, similarly to the conventional D/A converter 100 shown in Fig. 1, n-stage resistor ladder network 101 comprising resistors having values R and 2R and connected as seen in Fig. 1, n groups of serially connected inverters 102 and 103 and input terminals $IN_{n-1}$ to $IN_0$. The ladder network 101 and the inverters 102 and 103 constitute a digital-to-analog converting section 104 of this D/A converter 300. N-bit binary digital input data is supplied to the input terminals $IN_{n-1}$ to $IN_0$, wherein the MSB of the input data is supplied to the input terminal $IN_{n-1}$. This D/A converter 300 further comprises an exclusive-OR gate (hereinafter referred to as "EXOR gate") 301 whose one input terminal is connected to the input terminal $IN_{n-1}$. The other input terminal of the EXOR gate 301 is connected to an input terminal T0 to which a signal MS is applied to select a mode of error correction as more fully described later. An output terminal of the EXOR gate 301 is connected to an input terminal of an inverter 302 and also connected to one input terminals of AND gates 303 and 304. The other input terminals of the AND gates 303 and 304 are connected to input terminals T1 and T2, respectively. Output terminals of the inverter 302 and AND gate 303 are connected to input terminals of an OR gate 305. An output terminal of the OR gate 305 is connected to an input terminal of an inverter 306 which outputs a voltage equal to $V_{DD}$ as a logical "1" and outputs a ground level signal as a logical "0". An output terminal of the inverter 306 is connected to one terminal of a resistor 307 having a resistance value of 2R, and the other terminal of the resistor 307 is connected to one terminal of the R resister of the LSB stage of the ladder network 101, that is, one terminal end of the ladder network 101 on the LSB stage. An output terminal of the AND gate 304 is connected to an input terminal of an inverter 308 which outputs a voltage equal to $V_{DD}$ as a logical "1" and outputs a ground level signal as a logical "0". An output terminal of the inverter 308 is connected to one terminal of a resistor 308 of a resistance value of 2R, the other terminal of which is connected to the one terminal end of the ladder network 101. The inverter 302, the AND gates 303 and 304 and the OR gate 305 cooperate with the inverters 306 and 308 and the resistors 307 and 309 to form an error correction circuit 310 of this D/A converter 300.

With this arrangement, when one of the inverters 306 and 308 outputs the voltage $V_{DD}$ and when the other of the inverters 306 and 308 outputs the ground level signal, the circuit shown in Fig. 3 is equivalent to that shown in Fig. 1. On the other hand, when both of the inverters 306 and 308 output ground level signals, the resistance of the error correction circuit 310 viewed from the ladder network 101 becomes equal to R, so that, the circuit shown in Fig. 3 becomes equivalent to that shown in Fig 1 with the bias to the $2^{-1}$-bit stage thereof being changed from the voltage $V_{DD}$ to the ground level. And therefore, the output voltage $V_{OUT}$ in this case is always lower than that of the circuit shown in Fig. 1 by a voltage equal to $V_{LSB}/2$, the voltage $V_{LSB}$ being a voltage corresponding to the LSB or the $2^0$-bit of the input data.

When both of the inverters 306 and 308 output the voltage $V_{DD}$, the $2^{-1}$-bit stage of the ladder network 101 is biased by the voltage $V_{DD}$ twice as much as that shown in Fig. 1, so that the output voltage $V_{OUT}$ of the circuit shown in Fig. 3 is always higher than that of the circuit shown in Fig. 1 by the voltage $V_{LSB}/2$.

As described above, the output voltage $V_{OUT}$ of the D/A converter 300 shown in Fig. 3 can be shifted or offset selectively by one of the three different amounts of voltage, namely, zero, $+ V_{LSB}/2$ and $- V_{LSB}/2$. The selection of the shift amount of voltage is made in accordance with a signal S0 outputted from the EXOR gate 301, a signal S1 applied to the input terminal T1 and a signal S2 applied to the input terminal T2, as shown in Table 1.

TABLE 1

| S1 | S2 | S0 | amount of shift |
|----|----|----|-----------------|
| -  | -  | 0  | 0               |
| 0  | 0  | 1  | $+ V_{LSB}/2$   |
| 0  | 1  | 1  | 0               |
| 1  | 0  | 1  | 0               |
| 1  | 1  | 1  | $- V_{LSB}/2$   |

With this embodiment, if there exists an error in the D/A conversion, the amount of shift of the output voltage $V_{OUT}$ suitable for canceling the error is first determined. Then, the states of the signals S1, S2 and S0 are determined so that the above shift amount is selected at the error correction circuit 310. In this case, if the signal MS applied to the input terminal T0 is set to "1", the signal S0 becomes "1" when the MSB of the input data is "0". On the other hand, if the signal MS is set to "0", the signal S0 becomes "1" when the MSB of the input data is "1". And therefore, it can be determined in accordance with the state of the signal MS whether the correction should be made when the MSB of the input data is "1" or whether the correction should be made when the MSB of the input data is "0". The D/A converter 300 shown in Fig. 3 is so arranged that the correction is carried out in accordance with the state of the MSB of the input data. The reason for this is that the conversion error of the MSB is generally the largest. However, in the case where the conversion error of a bit of the input data other than the MSB thereof is the largest, the correction may be made in accordance with that bit.

Fig. 4 shows a modified D/A converter 400 which differs from the D/A converter 300 shown in Fig. 3 in that an error correction circuit 410 substitutes for the error correction circuit 310. This error correction circuit 410 comprises resistors 416 and 417 each having a resistance value of R and connected to the R resistor of the LSB stage of the R-2R ladder network 101, resistors 418 and 419 each having a resistance value of 2R and connected to the resister 416, resistors 420 and 421 each having a resistance value of 2R and connected to the resister 417, inverters 422 to 425 whose output terminals are connected respectively to resistors 418 to 421, and inverters 426 and 427 whose output terminals are connected respectively to input terminals of the inverters 423 and 424. The error correction circuit 410 also comprises inverters 428 and 429 whose input terminals are connected to input terminals T4 and T3, respectively. Output terminals of the inverters 428 and 429 are connected to first and third input terminals of an AND gate 430 whose second input terminal is supplied with the signal S0. Output terminal of the AND gate 430 is connected to an input terminal of the inverter 426 and a first input terminal of an OR gate 434 whose second input terminal is connected to an input terminal T5. The error correction circuit 410 further comprises a three-input AND gate 432 whose first to third input terminals are connected respectively to the input terminals T5 and T4 and the output terminal of the EXOR gate 301, and a two-input AND gate 433 whose first and second input terminals are connected respectively to the input terminal T3 and the output terminal of the EXOR gate 301. An output terminal of the AND gate 432 is connected to a first input terminal of an AND gate 431 whose second input terminal is connected to an output terminal of the AND gate 433. An output terminal of the AND gate 431 is connected to an input terminal of the inverter 427, and the output terminal of the AND gate 433 is connected to an input terminal of the inverter 425. The input terminals T3 to T5 are supplied with selection signals S3 to S5, respectively.

With this construction, the output voltage $V_{OUT}$ at the output terminal OUT can be shifted selectively by one of five different amounts of voltage, namely, zero, $+ V_{LSB}/2$, $- V_{LSB}/2$, $+ V_{LSB}/4$ and $- V_{LSB}/4$ in accordance with the states of the signal S0 and the signals S3 to S5, as shown in table 2.

TABLE 2

| S3 | S4 | S5 | S0 | amount of shift |
|----|----|----|----|-----------------|
| -  | -  | -  | 0  | 0 |
| 0  | 0  | 0  | 1  | $-V_{LSB}/2$ |
| 0  | 0  | 1  | 1  | $-V_{LSB}/4$ |
| 0  | 1  | 0  | 1  | 0 |
| 0  | 1  | 1  | 1  | $+V_{LSB}/4$ |
| 1  | 0  | 0  | 1  | $+V_{LSB}/2$ |

The operation of the D/A converter 400 will now be described with respect to each amount of shift.

(1)  Shift amount of zero

There are two kinds of combination of the states of the signals S0 and S3 to S5 to render the shift amount zero, as is appreciated from Table 2.  In either case, both of the inverters 422 and 423 output the voltages $V_{DD}$, and both of the inverters 424 and 425 output the ground level signals.  And therefore, the circuit of Fig. 4 in this case becomes equivalent to that of Fig. 1, so that the amount of shift of the output voltage $V_{OUT}$ is rendered zero.

(2)  Shift amount of $-V_{LSB}/2$

In this case, as will be apparent from the combination of the states of the signals S0 to S3 shown in Table 2 and the construction of the circuit of Fig. 4, all of the inverters 422 to 425 output ground level signals.  And therefore, the circuit of Fig. 4 becomes equivalent to that of Fig 1 with the bias to the $2^{-1}$-bit stage thereof changed from the voltage $V_{DD}$ to the ground level, so that the shift amount of the output voltage $V_{OUT}$ is rendered $- V_{LSB}/2.$

(3)  Shift amount of $- V_{LSB}/4$

In this case, the inverter 422 outputs the voltage $V_{DD}$, and the inverters 423 to 425 output the ground level signals. And therefore, the circuit of Fig. 4 becomes equivalent to the circuit of Fig. 1 with the bias to the $2^{-1}$-bit stage thereof being changed from the voltage $V_{DD}$ to the ground level and the bias to the $2^{-2}$-bit stage thereof applied, so that the shift amount of the output voltage $V_{OUT}$ becomes $- V_{LSB}/4$ ($- V_{LSB}/2 + V_{LSB}/4 = - V_{LSB}/4$).

(4)  Shift amount of $+ V_{LSB}/4$

In this case, the inverters 422 to 424 output the voltage $V_{DD}$, and the inverter 425 outputs the ground level signal. And therefore, the circuit of Fig. 4 becomes equivalent to the circuit of Fig. 1 with the bias to the $2^{-2}$-bit stage thereof applied, so that the shift amount of the output voltage $V_{OUT}$ is rendered $+ V_{LSB}/4.$

(5)  Shift amount of $+ V_{LSB}/2$

In this case, all of the inverters 422 to 425 output the voltage $V_{DD}$. And therefore, the circuit of Fig. 4 becomes equivalent to the circuit of Fig. 1 with another bias to the $2^{-1}$-bit stage of the ladder circuit additionally applied, so that the shift amount of the output voltage $V_{OUT}$ is rendered $+ V_{LSB}/2.$

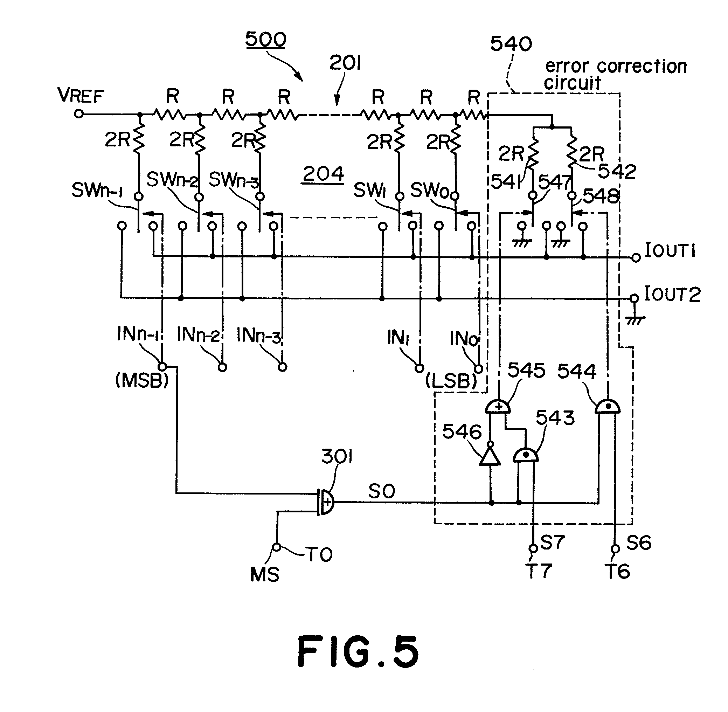

Fig. 5 shows a further modified D/A converter 500 of the current-output type which differs from the D/A converter 200 of Fig. 2 in that an EXOR gate 301 and an error correction circuit 540 are provided. The R-2R ladder network 201 and the

-13- 0177909

switches $SW_{n-1}$ to $SW_0$ constitute a digital-to-analog converting section 204 of this D/A converter 500.

The EXOR gate 301 is connected to the data input terminal $IN_{n-1}$ at one input terminal thereof and connected to the input terminal T0 at the other input terminal thereof. The output terminal of the EXOR gate 301 is connected to an input terminal of an inverter 546 and also connected to one input terminals of AND gates 543 and 544. The other input terminals of the AND gates 543 and 544 are connected to input terminals T7 and T6, respectively. These input terminals T6 and T7 are supplied respectively with selection signals S6 and S7. Output terminals of the inverter 546 and AND gate 543 are connected to input terminals of an OR gate 545. The one terminal end of the R-2R ladder network 201 on the LSB side thereof, that is, the one terminal of the R resistor of the LSB stage of the ladder network 201, is connected to one terminals of resistors 541 and 542 each having a resistance value of 2R. The other terminals of the resistors 541 and 542 are connected respectively to two-pole analog switches 547 and 548, each of which may be composed of a pair of field effect transistors complementarily connected to each other. An output signal of the OR gate 545 is supplied to the switch 547 in such a manner that the other terminal of the resistor 541 is grounded when the OR gate 545 outputs a "0" signal and that the other terminal of the resistor 541 is connected to the output terminal $I_{OUT1}$ when the AND gate 545 outputs a "1" signal. Similarly, an output signal of the AND gate 544 is supplied to the switch 548 in such a manner that the other terminal of the resistor 542 is grounded when the AND gate 544 outputs a "0" signal and that the other terminal of the resistor 542 is connected to the output terminal $I_{OUT1}$ when the AND gate 544 outputs a "1" signal.

With this arrangement, when the switches 547 and 548 are activated so that either of the other terminals of the resistors 541 and 542 is connected to the output terminal $I_{OUT1}$, the output current of this D/A converter 500 is increased or shifted by a current $I_{LSB}/2$, that is, half of the current equivalent to the LSB of the input data. On the other hand, when the switches 547 and 548 are activated so that both of the other terminals of the resistors 541 and 542 are connected to the output terminal $I_{OUT1}$, the output current of this D/A converter 500 is increased by a current $I_{LSB}$, that is, the current equivalent to the LSB of the input data. And therefore, the amount of shift of the output current of this D/A converter 500 varies in accordance with the states of the signals S0, S6 and S7, as shown in Table 3.

TABLE 3

| S7 | S6 | S0 | amount of shift |
|----|----|----|-----------------|
| 0 | 0 | 1 | 0 |
| 0 | 1 | 1 | $I_{LSB}/2$ |
| 1 | 0 | 1 | $I_{LSB}/2$ |
| 1 | 1 | 1 | $I_{LSB}$ |
| – | – | 0 | $I_{LSB}/2$ |

The error correction circuit 540 described above is also so arranged that the correction is carried out in accordance with the state of the MSB of the input data. However, in the case where the conversion error of a bit of the input data other than the MSB is the largest, the error correction circuit 540 may be modified so that the correction is made in accordance with that bit. Furthermore, if the correction need be made over a plurality of bits of the input data, a plurality of correction circuits 540 each operatively connected to a respective one of the plurality of bits may be provided.

0177909

CLAIMS:

1. A digital-to-analog converter comprising digital-to-analog converting means for converting digital input data comprising a plurality of bits into an analog output signal which is proportional in amount to said digital input data, said digital-to-analog converter characterized by the provision of error correction circuit means operatively connected to said digital-to-analog converting means for shifting said analog output signal by a predetermined amount in accordance with a state of data at a preselected bit of said digital input data.

2. A digital-to-analog converter according to claim 1, wherein said error correction circuit means shifts said analog output signal selectively by one of a plurality of predetermined amounts in accordance with the preselected bit of said digital input data.

3. A digital-to-analog converter according to claim 1 or claim 2, wherein said preselected bit is the most significant bit of said digital input data.

4. A digital-to-analog converter according to claim 1, wherein said error correction circuit means comprises:
    enabling circuit means responsive to a specific state of said bit of said digital input data for generating an enabling signal; and

signal generating means responsive to said enabling signal for generating an analog signal whose amount is a $2^{-N}$ (N is an integer) magnification of that amount of said analog output signal which corresponds to the least significant bit of said digital input data, said generated analog signal being fed to said digital-to-analog converting means to cause said analog output signal to be shifted by the amount of said generated analog signal.

5. A digital-to-analog converter according to claim 2, wherein said error correction circuit means comprises:

enabling circuit means responsive to a specific state of said bit of said digital input data for generating an enabling signal;

an input terminal for receiving a selection signal; and

analog signal generating means responsive to said enabling and selection signals for selectively generating one of a plurality of analog signals whose amounts are $2^{-N}$ (N are integers) magnifications of that amount of said analog output signal which corresponds to the least significant bit of said digital input data, said selectively generated analog signal being fed to said digital-to-analog converting means to cause said analog output signal to be shifted by the amount of said selectively generated analog signal.

6. A digital-to-analog converter according to claim 5, wherein said digital-to-analog converting means comprises a first R-2R resistor ladder network, said analog signal generating means comprising a second R-2R resistor ladder network connected to said first R-2R ladder network to form lower-significant-bit stages thereof.

**FIG.1**
(Prior Art)

**FIG.2**
(Prior Art)

FIG.3

FIG.4

**FIG.5**